# FASCICULE DE BREVET EUROPEEN

(11) **EP 0 425 383 B1**
(45) Date de publication et mention de la délivrance du brevet: **28.07.1993**
(21) Numéro de dépôt: 90403012.9
(22) Date de dépôt: 25.10.1990
(51) Int. Cl.: G01R 33/24

(54) **Flacon à double paroi pour sonde à RMN.**
Fläschchen mit doppelter Wand für magnetische Kernresonanz-Sonde
Bottle with double-wall for NMR probe

(30) Priorité: 27.10.1989 FR 8914150
(43) Date de publication de la demande: 02.05.1991
(73) Titulaire: COMMISSARIAT A L'ENERGIE ATOMIQUE, 75015 Paris (FR)
(72) Inventeur: Glenat, Henri, F-38700 Corenc (FR); Kernevez, Nelly, F-38000 Grenoble (FR)
(74) Mandataire: Mongrédien, André

(56) Documents cités:
- EP-A- 0 185 825
- EP-A- 0 206 931
- FR-A- 2 098 624
- US-A- 3 441 838

## Description

La présente invention a pour objet un flacon pour sonde de magnétomètre à résonance magnétique nucléaire (RMN en abrégé). Elle trouve une application dans la mesure précise des champs magnétiques, notamment du champ magnétique terrestre.

Le magnétomètre dans lequel est utilisée de préférence la sonde de l'invention est d'un type connu, tel que décrit notamment dans les brevets français FR-A-1 447 226 et FR-A-2 098 624. Il n'est donc pas utile de décrire en détail cet appareil. Il suffit de rappeler qu'il comprend un ou plusieurs flacons à échantillon liquide, disposé(s) dans une cavité résonnante coaxiale. Cette cavité est constituée d'un conducteur central traversant le flacon et d'une paroi extérieure conductrice, autour du flacon. La sonde comprend des enroulements de prélèvement et de réinjection d'un signal à la fréquence de LARMOR, laquelle est définie, d'une part, par le champ magnétique dans lequel baigne la sonde et, d'autre part, par le rapport gyromagnétique propre à l'échantillon liquide utilisé. L'une des extrémités du conducteur central est reliée à des condensateurs d'accord en fréquence et l'autre à un générateur de très haute fréquence (VHF).

Les solvants employés dans les échantillons liquides pour la réalisation de ces, sondes doivent présenter généralement des caractéristiques physiques particulières : point de congélation au-dessous d'environ -50°C, point d'ébullition au-dessus d'environ +70°C et même au-dessus de 125°C dans des applications particulières, faible viscosité, temps de relaxation des protons le plus long possible.

Pour absorber les variations de volume de ces liquides dans la plage de température de fonctionnement, il est indispensable de laisser une "bulle de vide" dans le flacon (environ 8% du volume total à une température de 20°C pour les solvants utilisés). Cette bulle permet au solvant de se dilater, sans que s'exerce une pression importante sur le flacon qui pourrait entraîner un risque d'explosion de celui-ci. En réalité, la bulle contient de la vapeur de solvant.

Selon l'orientation de la sonde dans l'espace, la bulle occupe différentes positions dans le flacon et peut venir se placer à proximité de régions à fort rendement de signal telles que les régions à proximité des enroulements de prélèvement. Ceci a pour effet de diminuer le rapport signal/bruit et d'augmenter par ailleurs le bruit lorsque la sonde est en mouvement. En outre, lorsque la bulle se place à proximité des condensateurs d'accord, le coefficient diélectrique du solvant pouvant être très élevé (33 pour le méthanol), cette bulle va modifier la capacité totale et désaccorder la cavité ; le champ VHF interne va diminuer, le coefficient de polarisation baisser et l'amplitude du signal diminuer. La diminution du rapport signal/bruit va laisser apparaître des effets parasites liés notamment à l'anisotropie de la sonde et le bruit de fond va augmenter.

C'est ainsi que le document EP-A-0 206 931 décrit une sonde de magnétomètre à RMN comprenant deux flacons constitués chacun par un hémisphère et une galette cylindrique. Lorsque le flacon se présente verticalement, la partie hémisphérique étant en haut, la bulle se place au sommet là où se trouve généralement le condensateur d'accord. Pour éviter le désaccord, le document EP-A-0 206 931 préconise alors de disposer le condensateur d'accord au centre de la cavité. Mais, dans la position inversée de la sonde, la bulle vient se loger dans la partie en forme de galette, là où se trouve alors le condensateur d'accord. Il y a donc encore perturbation (quoique plus faible que dans le cas précédent puisque la surface offerte à la bulle est plus grande et que la bulle est donc plus mince que dans la partie hémisphérique).

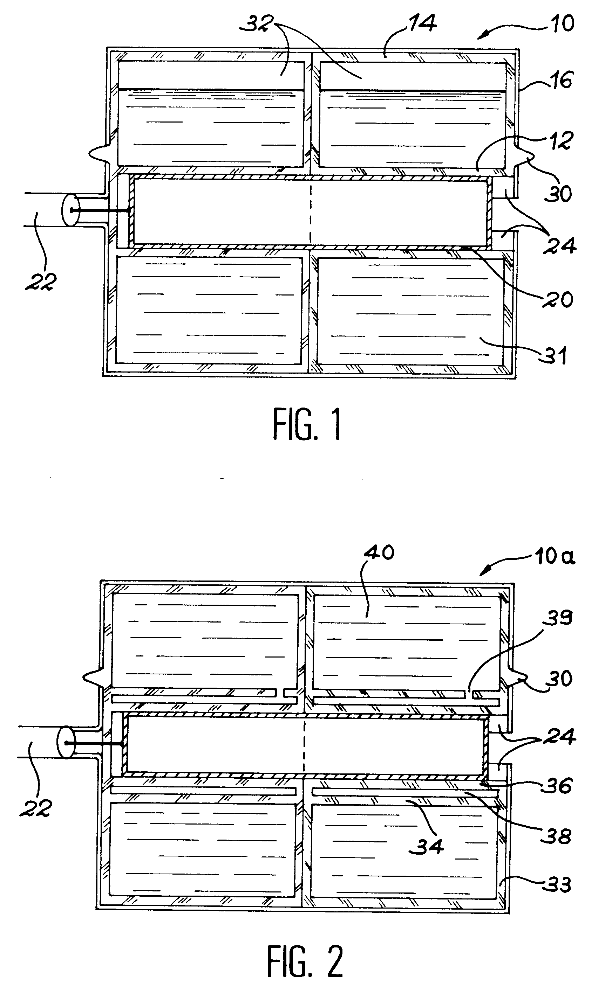

La figure 1 annexée permet de préciser ces problèmes dans le cas où les flacons sont cylindriques.

Le flacon 10 comprend une paroi intérieure cylindrique 12 ménageant un canal pour le passage du conducteur central du résonateur et une paroi extérieure 14. Le résonateur est défini, d'une part, par une couche conductrice 16 disposée sur la paroi extérieure 14 et, d'autre part, par le conducteur 20 occupant le canal défini par la paroi 12. Ce conducteur est relié à l'une de ses extrémités à un câble coaxial d'alimentation 22 et, à l'autre de ses extrémités, à des condensateurs d'accord 24.

Le remplissage du flacon s'effectue par un queusot 30. Après remplissage, le volume liquide 31 n'occupe pas totalement le flacon, une bulle 32 devant subsister.

Si cette bulle est indispensable, elle n'en demeure pas moins à l'origine de certains inconvénients. Elle conduit tout d'abord comme on l'a vu précédemment à une perte de signal lorsque l'orientation de la sonde est telle que la bulle vient se placer dans une zone où le rendement du liquide est élevé. Elle entraîne ensuite une anisotropie de la sonde, puisque la symétrie de révolution de l'ensemble est rompue. Enfin, elle conduit à une difficulté de remplissage, car il n'est pas aisé de calibrer le volume laissé vide.

La présente invention a justement pour but de remédier à ces inconvénients.

A cette fin, elle propose un moyen simple pour que la bulle soit située, en cours de fonctionnement, dans une zone qui contribue faiblement au signal de mesure, et pour que l'isotropie de la sonde soit préservée et enfin pour que soit simplifiée l'opération de remplissage.

Ces buts sont atteints selon l'invention par l'utilisation d'un flacon dont la caractéristique essentielle est que sa paroi intérieure est constituée par une double paroi définissant un volume coaxial correspondant sensiblement au volume vide devant subsister après remplissage ; la paroi extérieure de cette double paroi est percée d'au moins une ouverture faisant communiquer le volume coaxial avec le reste du flacon.

Les buts visés par l'invention sont bien atteints par une telle disposition. En effet, en cours de fonctionnement, la bulle occupera le volume défini par la double paroi, c'est-à-dire la zone entourant le conducteur central, zone relativement peu active. La perte en signal sera donc faible. Ensuite, la forme de révolution du volume vide préservera la symétrie de la sonde. Enfin, le remplissage sera très simple puisqu'il suffira de ne remplir à une température donnée que le volume principal, en laissant vide la partie coaxiale délimitée par la double paroi. A cette température, le volume défini par la double paroi est exempt de liquide et permet en outre d'éviter le désaccord de la cavité à ladite température.

De toute façon, les caractéristiques et avantages de l'invention apparaîtront mieux à la lumière de la description qui suit, d'exemples de réalisation donnés à titre explicatif et nullement limitatif. Cette description se réfère à des dessins annexés sur lesquels :
- la figure 1, déjà décrite, montre des flacons pour sonde à RMN selon l'art antérieur ;
- la figure 2 montre des flacons selon l'invention dans une variante cylindrique ;
- la figure 3 montre un flacon selon l'invention dans une variante hémisphérique à galette.

On voit, sur la figure 2, un flacon 10a avec une paroi extérieure cylindrique 33 et une paroi intérieure constituée par une double paroi 34, 36, ménageant un volume coaxial 38. Le diamètre des deux parois 34, 36 est défini de telle sorte que le volume de l'espace qu'elles délimitent soit sensiblement égal au vide que l'on désire laisser dans le flacon après remplissage, soit approximativement 8%. La paroi extérieure 34 est percée d'une ouverture 39, qui fait communiquer le volume 38 avec le volume principal 40 du flacon. Plusieurs trous peuvent être prévus. Leur diamètre peut être de l'ordre de 1 à 2 mm.

On retrouve par ailleurs le conducteur central 20 occupant le canal défini par la paroi 36 et divers équipements (câble 22, condensateurs 24).

L'énergie VHF fournie au liquide pour l'excitation du phénomène de polarisation dynamique se perd en partie par effet Joule dans le conducteur central 20, de sorte qu'il se produit dans cette zone une légère augmentation de température lors de la mise en fonctionnement de la sonde. Cette élévation se fait d'abord sentir dans le volume 38, à l'intérieur de la double paroi. Une légère augmentation de pression en résulte, qui a pour effet de chasser partiellement ou totalement suivant la température d'utilisation le liquide à travers l'orifice 39 vers le volume principal 40.

Ce phénomène d'éjection du liquide de la zone centrale 38 vers la zone périphérique 40 est quasiment instantané pour les solvants généralement utilisés en RMN (comme le THF ou tétrahydrofurane). Il est d'autant plus rapide que la température de fonctionnement est basse.

En fonctionnement normal, le liquide occupe donc le volume principal 40, comme représenté sur la figure 2. L'espace coaxial 38 de la double paroi est vide à la température de remplissage, ce qui tient lieu de "bulle". Mais contrairement à l'art antérieur, cette "bulle" est coaxiale, donc parfaitement symétrique.

L'invention qui vient d'être décrite peut s'appliquer à toute forme de flacons (hémisphérique, cylindrique, conique, etc...) dès lors qu'il existe une paroi intérieure cylindrique délimitant un passage pour le conducteur central du résonateur.

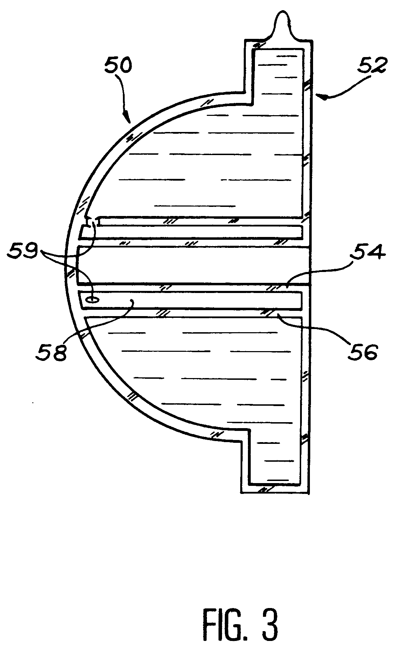

La figure 3 montre ainsi un flacon selon l'invention avec une partie hémisphérique 50 et une galette 52. La double paroi 54, 56 définit un volume coaxial 58. Le tube extérieur 56 est percé de trois trous 59 à 120°, pour l'éjection du liquide dans le volume principal.

Le flacon peut être en tout matériau connu dans cette application, et par exemple en verre de la marque Pyrex.

## Revendications

1. Flacon pour sonde à résonance magnétique nucléaire, comprenant une paroi intérieure cylindrique (12) ménageant un canal pour le passage d'un conducteur central (20) et une paroi extérieure (14), ce flacon étant destiné à être incomplétement rempli de liquide (31), un volume vide (32) devant subsister après remplissage, ce flacon étant caractérisé par le fait que la paroi intérieure est constituée par une double paroi (34, 36), (54, 56) définissant un volume coaxial (38), (58) correspondant sensiblement au volume vide devant subsister après remplissage, la paroi extérieure (34) de la double paroi étant percée d'au moins une ouverture (39, 59) faisant communiquer le volume coaxial (38, 58) avec le reste du flacon.

2. Flacon selon la revendication 1, caractérisé par le fait que la paroi extérieure (14)(33) est cylindrique.

3. Flacon selon la revendication 1, caractérisé par le fait que le flacon a une forme générale hémisphérique (50) avec une galette (52).

## Patentansprüche

1. Fläschchen für magnetische Kernresonanz-Sonde, welches eine zylindrische innere Wand (12), die einen Kanal für den Durchgang eines zentralen Leiters (20) ausspart, und eine äußere Wand (14) umfaßt, wobei dieses Fläschchen dazu bestimmt ist, unvollständig mit Flüssigkeit (31) aufgefüllt zu werden, und nach dem Auffüllen ein Hohlraum (32) entstehen muß, wobei dieses Fläschchen dadurch gekennzeichnet ist, daß die innere Wand durch eine Doppelwand (34, 36) gebildet wird, wobei (54, 56) ein koaxiales Volumen (38) definieren, (58) genau dem Hohlraum entspricht, der sich nach dem Auffüllen bilden muß und die äußere Wand (34) der Doppelwand von mindestens einer Öffnung (39, 59) durchbrochen ist, die das koaxiale Volumen (38, 58) mit dem Rest des Fläschchens kommunizieren läßt.

2. Fläschchen gemäß Anspruch 1, dadurch gekennzeichnet, daß die äußere Wand (14, 33) zylindrisch ist.

3. Fläschchen gemäß Anspruch 1, dadurch gekennzeichnet, daß das Fläschchen eine allgemeine Halbkugelform (50) mit einer Platte (52) hat.

## Claims

1. Bottle for nuclear magnetic resonance probe, comprising an inner cylindrical wall (12) leaving a duct for the passage of a central conductor (20) and an outer wall (14), said bottle being intended to be incompletely filled with liquid (31), an empty volume (32) being left after filling, said bottle being characterized in that the inner wall is constituted by a double wall (34, 36, 54, 56) defining a coaxial volume (38, 58) substantially corresponding to the empty volume to be left after filling, the outer wall (34) of the double wall having at least one opening (39, 59) for linking the coaxial volume (38, 58) with the remainder of the bottle.

2. Bottle according to claim 1, characterized in that the outer wall (14, 33) is cylindrical.

3. Bottle according to claim 1, characterized in that the bottle has a generally hemispherical (50) shape with a flat portion (52).
